# EUROPÄISCHE PATENTANMELDUNG

(11) **EP 4 440 260 A1**
(43) Veröffentlichungstag der Anmeldung: **02.10.2024**
(21) Anmeldenummer: 23164645.6
(22) Anmeldetag: 28.03.2023
(51) Int. Cl.: H05K 7/14, H05K 7/20

(54) **ELEKTRONISCHE LEISTUNGSBAUGRUPPE MIT VEREINFACHTEM AUFBAU**

(71) Anmelder: Siemens Aktiengesellschaft, 80333 München (DE)
(72) Erfinder: Frana, Christian, 90556 Cadolzburg (DE); Honig, Jonas, 90491 Nürnberg (DE); Nieberlein, Klaus, 90471 Nürnberg (DE); Rövenstrunck, Martin, 91126 Schwabach (DE)
(74) Vertreter: Siemens Patent Attorneys

(57) **Zusammenfassung**

Ein Leistungsmodul (1) weist eine Moduloberseite (3) und eine Modulunterseite (4) auf. Das Leistungsmodul (1) ist mit der Modulunterseite (4) über in einen Kühlkörper (9) eingedrehte Befestigungsschrauben (11) an den Kühlkörper (9) angedrückt. Eine Leiterplatte (13) weist eine Leiterplattenoberseite (14) und eine Leiterplattenunterseite (15) sowie Durchtrittsöffnungen (16) für den Durchtritt der Befestigungsschrauben (11) auf. Die Leiterplatte (13) ist an der Moduloberseite (3) angeordnet ist, so dass die Leiterplattenunterseite (15) der Moduloberseite (3) zugewandt ist. Sie ist mit dem Leistungsmodul (1) mechanisch und elektrisch verbunden. Eine aus einem elektrisch isolierenden Basismaterial, insbesondere einem Kunststoff, bestehende Brückenstruktur (17) weist hülsenartige Führungen (18) auf, die über Verbindungsbereiche (19) der Brückenstruktur (17) miteinander verbunden sind. Die Verbindungsbereiche (19) weisen oberhalb der Leiterplattenoberseite (14) mit einem Abstand (a) zur Leiterplattenoberseite (14) angeordnete Abschnitte (20) auf, die an ihrer von der Leiterplatte (13) abgewandten Seite parallel zur Leiterplatte (13) verlaufende Montageflächen (21) bilden, so dass die Abschnitte (20) eine Montageebene für weitere Elemente (22) der Leistungsbaugruppe bereitstellen. Die Führungen (18) erstrecken sich durch die Durchtrittsöffnungen (16) der Leiterplatte (13) hindurch zum Leistungsmodul (1), so dass die in den Kühlkörper (9) eingedrehten Befestigungsschrauben (11) das Leistungsmodul (1) über die Führungen (18) der Brückenstruktur (17) an den Kühlkörper (9) andrücken.

## Beschreibung

Die vorliegende Erfindung geht aus von einer elektronischen Leistungsbaugruppe,
- wobei die Leistungsbaugruppe ein Leistungsmodul mit einer Moduloberseite und einer Modulunterseite aufweist,
- wobei die Leistungsbaugruppe einen Kühlkörper aufweist, an den das Leistungsmodul mit der Modulunterseite über in den Kühlkörper eingedrehte Befestigungsschrauben angedrückt ist,
- wobei die Leistungsbaugruppe eine Leiterplatte mit einer Leiterplattenoberseite und einer Leiterplattenunterseite aufweist,
- wobei die Leiterplatte Durchtrittsöffnungen für den Durchtritt der Befestigungsschrauben aufweist,
- wobei die Leiterplatte an der Moduloberseite angeordnet ist, so dass die Leiterplattenunterseite der Moduloberseite zugewandt ist, und mit dem Leistungsmodul mechanisch und elektrisch verbunden ist.

Derartige Leistungsbaugruppen sind allgemein bekannt. Sie werden beispielsweise als Stromversorgungseinrichtungen für elektrische Antriebe eingesetzt.

Im Stand der Technik wirken die Befestigungsschrauben direkt auf das Leistungsmodul. Dadurch ergeben sich verschiedene Nachteile. Zunächst müssen die Durchtrittsöffnungen der Leiterplatte einen nennenswerten Durchmesser aufweisen, damit nicht nur die Hälse der Befestigungsschrauben, sondern auch die Köpfe der Befestigungsschrauben durch die Durchtrittsöffnungen hindurch treten können. Weiterhin können Bereiche der Leiterplatte um die Durchtrittsöffnungen herum oftmals nicht für Leiterbahnen genutzt werden, da anderenfalls erforderliche Luft- und Kriechstrecken zwischen den Befestigungsschrauben und den Leiterbahnen nicht eingehalten werden können.

Weiterhin ist es auch erforderlich, die elektrische und mechanische Verbindung der Leiterplatte und des Leistungsmoduls stabil und zuverlässig zu gestalten. Zu diesem Zweck weist die Leiterplatte oftmals weitere Durchtrittsöffnungen auf, durch die weitere Befestigungsschrauben hindurch treten können. Die weiteren Befestigungsschrauben werden in diesem Fall in das Leistungsmodul eingedreht und drücken die Leiterplatte hatte an das Leistungsmodul an. Durch die weiteren Befestigungsschrauben und eventuell auch hier wieder einzuhaltende Luft- und Kriechstrecken verringert sich der auf der Leiterplatte für Leiterbahnen zur Verfügung stehende Platz noch weiter.

Die Aufgabe der vorliegenden Erfindung besteht darin, Möglichkeiten zu schaffen, mittels derer auf einfache und zuverlässige Art und Weise und mit geringem Platzbedarf die erforderlichen Verbindungen zwischen dem Kühlkörper, dem Leistungsmodul und der Leiterplatte hergestellt werden können und darüber hinaus auch der sonstige Aufbau der Leistungsbaugruppe vereinfacht wird.

Die Aufgabe wird durch eine elektronische Leistungsbaugruppe mit den Merkmalen des Anspruchs 1 gelöst. Vorteilhafte Ausgestaltungen der Leistungsbaugruppe sind Gegenstand der abhängigen Ansprüche 2 bis 5.

Erfindungsgemäß wird eine elektronische Leistungsbaugruppe der eingangs genannten Art dadurch ausgestaltet,
- dass die Leistungsbaugruppe eine aus einem elektrisch isolierenden Basismaterial, insbesondere einem Kunststoff, bestehende Brückenstruktur aufweist,
- dass die Brückenstruktur hülsenartige Führungen aufweist, die über Verbindungsbereiche der Brückenstruktur miteinander verbunden sind,
- wobei die Verbindungsbereiche oberhalb der Leiterplattenoberseite mit einem Abstand zur Leiterplattenoberseite angeordnete Abschnitte aufweisen, die an ihrer von der Leiterplatte abgewandten Seite parallel zur Leiterplatte verlaufende Montageflächen bilden, so dass die Abschnitte eine Montageebene für weitere Elemente der Leistungsbaugruppe bereitstellen, und
- dass die Führungen sich durch die Durchtrittsöffnungen der Leiterplatte hindurch zum Leistungsmodul erstrecken, so dass die in den Kühlkörper eingedrehten Befestigungsschrauben das Leistungsmodul über die Führungen der Brückenstruktur an den Kühlkörper andrücken.

Vorzugsweise sind die Führungen derart dimensioniert, dass Schraubenköpfe der Befestigungsschrauben oberhalb der Leiterplattenoberseite angeordnet sind. Dadurch ergeben sich bereits ganz von selbst Luftstrecken zur Leiterplatte.

Die Luftstrecken und auch Kriechstrecken können dadurch noch weiter vergrößert werden, dass die Brückenstruktur Trennelemente aufweist, welche die Schraubenköpfe der Befestigungsschrauben vollständig oder nahezu vollständig umgeben.

Vorzugsweise sind die Führungen weiterhin derart dimensioniert, dass die Schraubenköpfe der Befestigungsschrauben unterhalb der von den Abschnitten bereitgestellten Montageebene angeordnet sind. Dadurch ergeben sich zum einen ganz von selbst Luftstrecken zur von den Abschnitten bereitgestellten Montageebene. Zum anderen kann die von den Abschnitten bereitgestellte Montageebene auf einfache Weise durchgängig gestaltet werden, also ohne dass die Schraubenköpfe der Befestigungsschrauben stören könnten.

Es ist möglich, dass das Basismaterial bereits eine hinreichende Materialfestigkeit aufweist, um die von den Befestigungsschrauben ausgeübten Kräfte auf das Leistungsmodul zu übertragen. Alternativ ist es möglich, dass die Führungen an ihren den Befestigungsschrauben zugewandten Innenseiten Verstärkungshülsen aus einem Zusatzmaterial aufweisen, das eine höhere Materialfestigkeit aufweist als das Basismaterial.

Das Zusatzmaterial kann ebenfalls elektrisch isolierend sein. Beispielsweise kann es sich ebenfalls um einen Kunststoff handeln. Auch kann es sich um eine Keramik handeln. Alternativ kann das Zusatzmaterial elektrisch leitend sein, insbesondere aus Stahl, Messing oder einem anderen Metall bzw. einer metallischen Legierung bestehen. Die elektrische Leitfähigkeit des Zusatzmaterials ist unkritisch, weil die erforderlichen Luft- und Kriechstrecken, die zwischen den Befestigungsschrauben und den Leiterbahnen der Leiterplatte (und gegebenenfalls der Montageebene für die weiteren Elemente) eingehalten werden müssen, durch die Gestaltung der Brückenstruktur gewährleistet sein können. Insbesondere auf Metallen und Metalllegierungen basierende Materialien weisen jedoch oftmals erheblich größere strukturelle Festigkeiten auf, als sie mit Kunststoffen erreichbar sind.

Vorzugsweise weist die Brückenstruktur an ihrer der Leiterplattenoberseite zugewandten Seite elastische Andruckelemente auf, mittels derer die Leiterplatte an das Leistungsmodul angedrückt wird. Dadurch können die weiteren Befestigungselemente, die im Stand der Technik zum Andrücken der Leiterplatte an das Leistungsmodul erforderlich sind, und auch die hierfür erforderlichen weiteren Durchtrittsöffnungen entfallen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine elektronische Leistungsbaugruppe im Schnitt,
- FIG 2: eine Draufsicht von oben auf ein Leistungsmodul und
- FIG 3: einen Schnitt durch das Leistungsmodul von FIG 2,
- FIG 4: einen Schnitt durch einen Teil einer elektronischen Leistungsbaugruppe im Bereich einer Führung,
- FIG 5: eine elektronische Leistungsbaugruppe im Schnitt,
- FIG 6: eine elektronische Leistungsbaugruppe im Schnitt,
- FIG 7: eine perspektivische Schnittdarstellung der elektronischen Leistungsbaugruppe von FIG 5 und
- FIG 8: eine elektronische Leistungsbaugruppe im Schnitt.

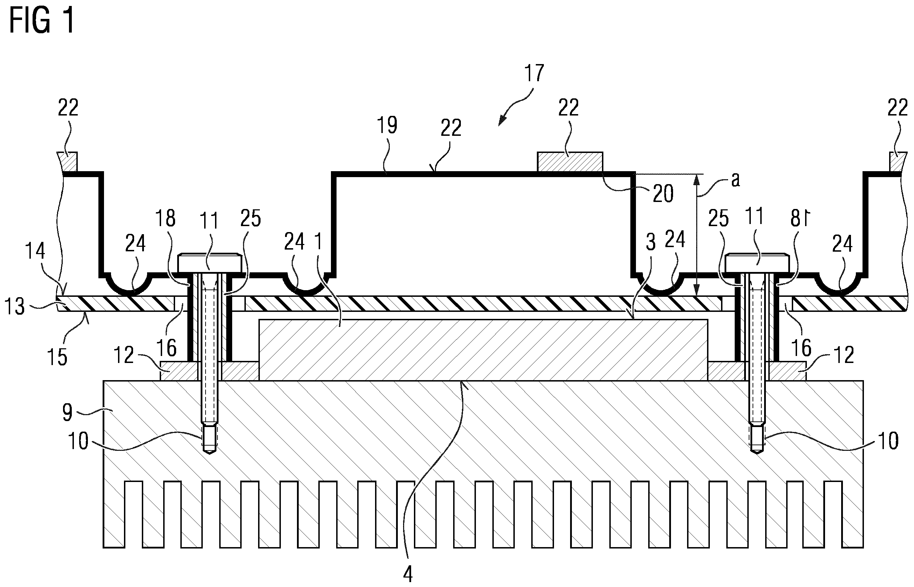

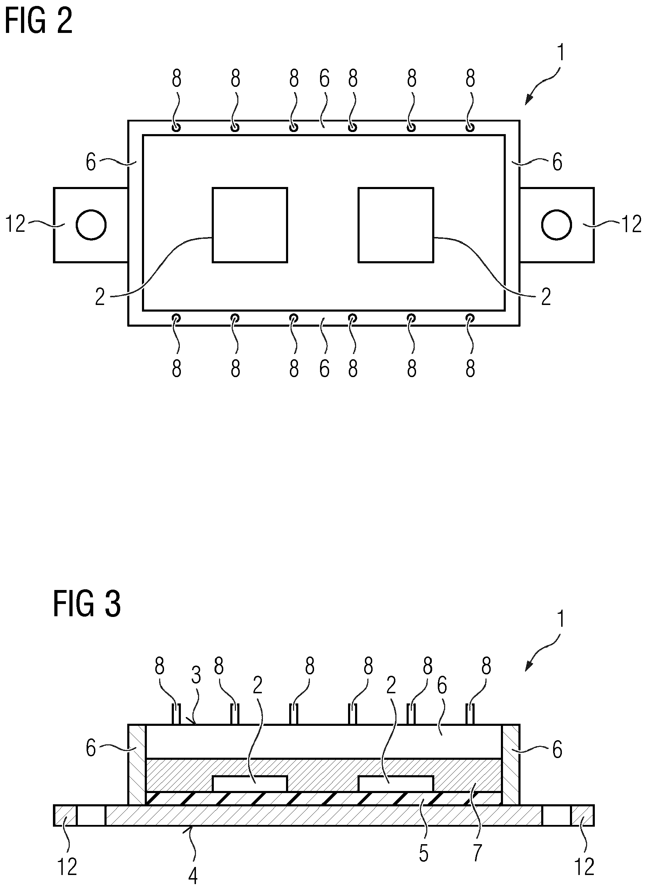

Gemäß FIG 1 weist eine elektronische Leistungsbaugruppe ein Leistungsmodul 1 auf. Das Leistungsmodul 1 umfasst gemäß der Darstellung in den FIG 2 und 3 üblicherweise eine Anzahl von Halbleiterschaltern 2. Die in den FIG 2 und 3 dargestellte Anzahl von zwei Halbleiterschaltern 2 ist jedoch nicht beschränkend zu verstehen.

Die Halbleiterschalter 2 schalten üblicherweise eine Spannung, die im Bereich von mehreren 100 V bis teilweise etwas über 1 kV liegt und in Einzelfällen sogar bei noch größeren Werten bis beispielsweise 3 kV oder 3,3 kV liegen kann. Im durchgeschalteten Zustand können die Halbleiterschalter 2 Ströme führen, die meist im Bereich von etlichen Ampere (typischerweise 50 A bis mehrere 100 A) liegen können. Oftmals realisiert das Leistungsmodul 1 mittels seiner Halbleiterschalter 2 und deren Verschaltung eine Anzahl von Brückenzweigen eines Umrichters. Innerhalb eines derartigen Brückenzweiges bilden die Halbleiterschalter 2 eine Reihenschaltung, wobei die beiden Enden der Reihenschaltung mit entsprechenden Gleichspannungspotenzialen verbunden werden können und zwischen zwei der Halbleiterschalter 2 der jeweiligen Reihenschaltung ein Abgriff für eine Wechselspannung vorhanden ist.

Das Leistungsmodul 1 weist eine Moduloberseite 3 und eine Modulunterseite 4 auf. Die Richtung von der Moduloberseite 3 zur Modulunterseite 4 (oder umgekehrt) definiert eine Höhenrichtung des Leistungsmoduls 1. Oftmals ist das Leistungsmodul 1 entsprechend der Darstellung in den FIG 2 und 3 im wesentlichen quaderförmig ausgebildet, wobei die Höhe des Leistungsmoduls 1 deutlich kleiner als die Länge und die Breite des Leistungsmoduls 1 ist.

Intern weist das Leistungsmodul 1 entsprechend der Darstellung in FIG 3 üblicherweise im Bereich der Modulunterseite 4 eine Trägerstruktur 5 auf, auf der die Halbleiterschalter 2 angeordnet sind. Die Trägerstruktur 5 kann beispielsweise ein Substrat sein. Weiterhin weist das Leistungsmodul 1 entsprechend der Darstellung in den FIG 2 und 3 oftmals Seitenwände 6 auf, so dass die Trägerstruktur 5 und die Seitenwände 6 zusammen eine Art Trog bilden. Der Trog ist oftmals mit einer Vergussmasse 7 (siehe FIG 3) vergossen. Weiterhin erstrecken sich von der Oberkante der Seitenwände 6 (deren Oberkante der Moduloberseite 3 entspricht) oftmals Anschlussstifte 8 nach oben, ragen also aus der Moduloberseite 3 heraus.

Der vorstehend erläuterte Aufbau des Leistungsmoduls 1 ist zwar allgemein üblich, letztendlich jedoch von untergeordneter Bedeutung. Auch die Anzahl und die Anordnung der Anschlussstifte 8 ist von untergeordneter Bedeutung. Von Bedeutung ist jedoch, dass gemäß FIG 1 das Leistungsmodul 1 mit der Modulunterseite 4 an einen Kühlkörper 9 angedrückt ist und damit im Ergebnis die Trägerstruktur 5 und die Halbleiterschalter 2 thermisch an den Kühlkörper 9 angekoppelt sind. Zwischen der Modulunterseite 4 und dem Kühlkörper 9 kann eine Wärmeleitpaste oder dergleichen vorhanden sein. Dies ist jedoch nicht zwingend erforderlich.

Zum Andrücken des Leistungsmoduls 1 an den Kühlkörper 9 sind in den Kühlkörper 9 Gewinde 10 eingebracht, in die Befestigungsschrauben 11 eingedreht sind. Mittels der Befestigungsschrauben 11 wird das Leistungsmodul 1 an den Kühlkörper 9 angedrückt.

Gemäß der Darstellung in den FIG 1 bis 3 weist das Leistungsmodul 1 Laschen 12 auf, die seitlich über das eigentliche Leistungsmodul 1 hinausragen. Bei der Ausgestaltung gemäß den FIG 1 bis 3 werden mittels der Befestigungsschrauben 11 primär die Laschen 12 an den Kühlkörper 9 angedrückt. Das Andrücken des Leistungsmoduls 1 wird indirekt durch die starre Verbindung der Laschen 12 mit dem Leistungsmodul 1 bewirkt.

Diese Ausgestaltung ist üblich, jedoch nicht zwingend erforderlich. Alternativ könnte mittels der Befestigungsschraube 11 auch auf die Moduloberseite 3 Druck ausgeübt werden.

Die Leistungsbaugruppe weist gemäß FIG 1 weiterhin eine Leiterplatte 13 mit einer Leiterplattenoberseite 14 und einer Leiterplattenunterseite 15 auf. Die Leiterplatte 13 ist an der Moduloberseite 3 angeordnet, so dass die Leiterplattenunterseite 15 der Moduloberseite 3 zugewandt ist. In der Regel liegt die Leiterplatte 13 auf der Moduloberseite 3 auf. Der in FIG 1 dargestellte kleine Abstand dient lediglich der besseren Erläuterung.

Die Leiterplatte 13 ist mit dem Leistungsmodul 1 elektrisch und mechanisch verbunden. Die mechanische und elektrische Verbindung der Leiterplatte 13 mit dem Leistungsmodul 1 kann beispielsweise durch das Aufsetzen der Leiterplatte 13 auf das Leistungsmodul 1 bzw. auf die Anschlussstifte 8 hergestellt werden. Die genaue Art und Weise der elektrischen und mechanischen Verbindung ist jedoch von untergeordneter Bedeutung. In jedem Fall aber weist die Leiterplatte 13 Durchtrittsöffnungen 16 auf, durch welche die Befestigungsschrauben 11 hindurch treten können.

Die Leistungsbaugruppe weist gemäß FIG 1 weiterhin eine Brückenstruktur 17 auf. Die Brückenstruktur 17 besteht aus einem elektrisch isolierenden Material, das nachfolgend als Basismaterial bezeichnet wird. Das Basismaterial kann insbesondere ein Kunststoff sein.

Die Brückenstruktur 17 weist gemäß FIG 1 hülsenartige Führungen 18 und Verbindungsbereiche 19 auf. Die Führungen 18 sind über die Verbindungsbereiche 19 miteinander verbunden. Die Verbindungsbereiche 19 weisen Abschnitte 20 auf, die oberhalb der Leiterplattenoberseite 14 mit einem Abstand a zur Leiterplattenoberseite 14 angeordnet sind. Die Abschnitte 20 bilden an ihrer von der Leiterplatte 13 abgewandten Seite Montageflächen 21. Die Montageflächen 21 verlaufen parallel zur Leiterplatte 13. Dadurch stellen die Abschnitte 20 eine Montageebene für weitere Elemente 22 der Leistungsbaugruppe bereit. Gegebenenfalls können die Montageflächen 21 zugleich auch Führungsstrukturen für die weiteren Elemente 22 umfassen. Die weiteren Elemente 22 können beispielsweise Stromschienen sein, welche auf den Montageflächen 21 angeordnet sind.

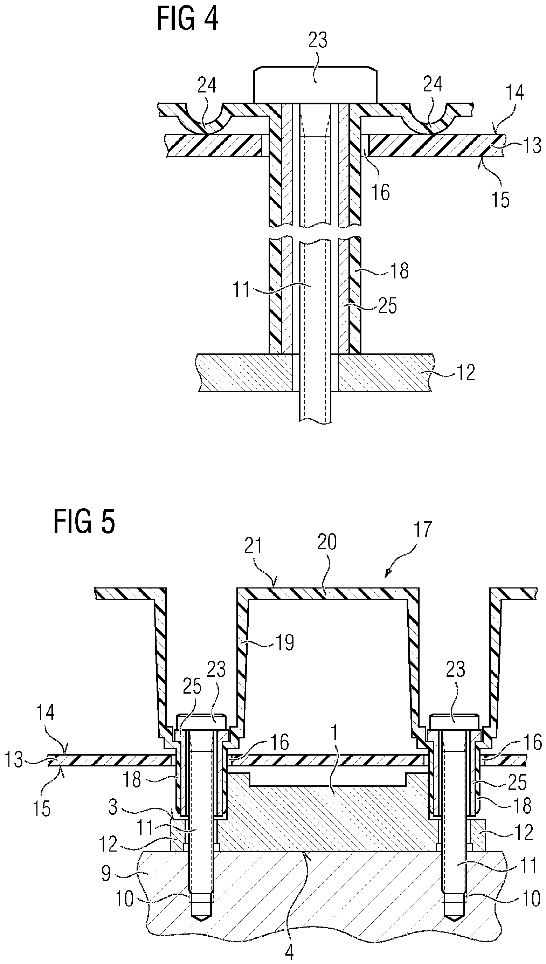

Die Führungen 18 erstrecken sich gemäß der Darstellung in FIG 1 (siehe auch FIG 4) durch die Durchtrittsöffnungen 16 der Leiterplatte 13 hindurch zum Leistungsmodul 1. Die Befestigungsschrauben 11 (genauer: deren Schraubenköpfe 23) wirken direkt auf die Führungen 18 (genauer: auf die von dem Leistungsmodul 1 beabstandeten Enden der Führungen 18). Weiterhin wirken die Führungen 18 (genauer: die auf dem Leistungsmodul 1 aufliegenden Enden der Führungen 18) auf das Leistungsmodul 1. Im Ergebnis drücken somit die Befestigungsschrauben 11 das Leistungsmodul 1 über die Führungen 18 der Brückenstruktur 17 an den Kühlkörper 9 an.

In FIG 1 sind weiterhin auch einige vorteilhafte Ausgestaltungen der elektronischen Leistungsbaugruppe dargestellt.

So ist beispielsweise aus FIG 1 erkennbar, dass die Führungen 18 derart dimensioniert sind, dass die Schraubenköpfe 23 der Befestigungsschrauben 11 oberhalb der Leiterplattenoberseite 14 angeordnet sind. Weiterhin ist aus FIG 1 erkennbar, dass die Führungen 18 derart dimensioniert sind, dass die Schraubenköpfe 23 unterhalb der von den Abschnitten 20 bereitgestellten Montageebene 21 angeordnet sind. Schließlich ist aus FIG 1 erkennbar, dass die Brückenstruktur 17 elastische Andruckelemente 24 aufweist. Die Andruckelemente 24 sind an der der Leiterplattenoberseite 14 zugewandten Seite der Brückenstruktur 17 angeordnet. Mittels der Andruckelemente 24 wird die Leiterplatte 13 an das Leistungsmodul 1 angedrückt wird.

FIG 4 zeigt eine weitere mögliche vorteilhafte Ausgestaltung der elektronischen Leistungsbaugruppe. Gemäß FIG 4 weisen die Führungen 18 an ihren den Befestigungsschrauben 11 zugewandten Innenseiten Verstärkungshülsen 25 auf. Die Verstärkungshülsen 25 bestehen aus einem anderen Material als die Brückenstruktur 17, insbesondere die Außenbereiche der Führungen 18. Dieses Material - nachfolgend als Zusatzmaterial bezeichnet - weist eine höhere Materialfestigkeit auf als das Basismaterial. Beispielsweise kann das Zusatzmaterial eine Keramik oder ein Metall (insbesondere Stahl oder Messing) sein. Das Vorhandensein der Verstärkungshülsen 25 weist den Vorteil auf, dass nur die Verstärkungshülsen 25 die mechanische Stabilität aufweisen muss, die zum Übertragen der Andruckkräfte erforderlich ist.

Die wesentlichen Sachverhalte der vorliegenden Erfindung sind auch aus den FIG 5 bis 8 erkennbar. Da die wesentlichen Elemente der vorliegenden Erfindung bereits erläutert sind, erfolgt bezüglich der FIG 5 bis 8 keine detaillierte Beschreibung. Stattdessen wird auf die Bezugszeichen der FIG 5 bis 8 verwiesen.

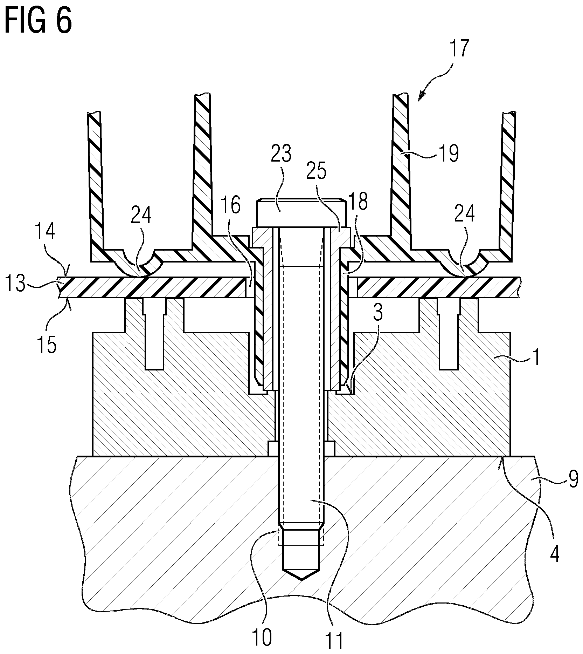

Konkret zeigen die FIG 5 und 6 einen Schnitt durch ein Leistungsmodul ähnlich zu FIG 1. Der Unterschied zwischen der Ausgestaltung von FIG 5 und der Ausgestaltung von FIG 6 besteht darin, dass bei der Ausgestaltung gemäß FIG 6 die Andruckelemente 24 vorhanden sind, während bei der Ausgestaltung gemäß FIG 5 keine Andruckelemente vorhanden sind.

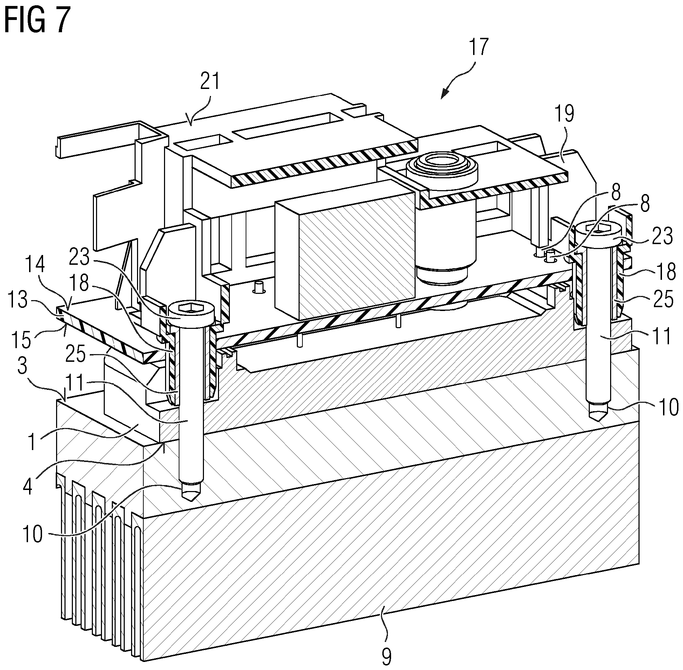

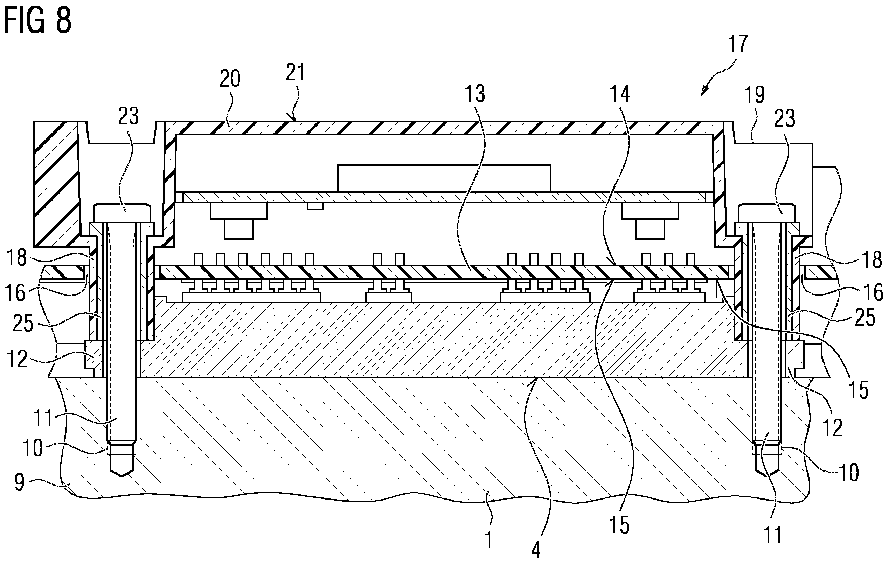

FIG 7 zeigt den Schnitt von FIG 5 in der Perspektive. FIG 8 zeigt wieder einen Schnitt ähnlich zu den FIG 1 und 5.

Zusammengefasst betrifft die vorliegende Erfindung somit folgenden Sachverhalt:
Ein Leistungsmodul 1 weist eine Moduloberseite 3 und eine Modulunterseite 4 auf. Das Leistungsmodul 1 ist mit der Modulunterseite 4 über in einen Kühlkörper 9 eingedrehte Befestigungsschrauben 11 an den Kühlkörper 9 angedrückt. Eine Leiterplatte 13 weist eine Leiterplattenoberseite 14 und eine Leiterplattenunterseite 15 sowie Durchtrittsöffnungen 16 für den Durchtritt der Befestigungsschrauben 11 auf. Die Leiterplatte 13 ist an der Moduloberseite 3 angeordnet, so dass die Leiterplattenunterseite 15 der Moduloberseite 3 zugewandt ist. Sie ist mit dem Leistungsmodul 1 mechanisch und elektrisch verbunden. Eine aus einem elektrisch isolierenden Basismaterial, insbesondere einem Kunststoff, bestehende Brückenstruktur 17 weist hülsenartige Führungen 18 auf, die über Verbindungsbereiche 19 der Brückenstruktur 17 miteinander verbunden sind. Die Verbindungsbereiche 19 weisen oberhalb der Leiterplattenoberseite 14 mit einem Abstand a zur Leiterplattenoberseite 14 angeordnete Abschnitte 20 auf, die an ihrer von der Leiterplatte 13 abgewandten Seite parallel zur Leiterplatte 13 verlaufende Montageflächen 21 bilden, so dass die Abschnitte 20 eine Montageebene für weitere Elemente 22 der Leistungsbaugruppe bereitstellen. Die Führungen 18 erstrecken sich durch die Durchtrittsöffnungen 16 der Leiterplatte 13 hindurch zum Leistungsmodul 1, so dass die in den Kühlkörper 9 eingedrehten Befestigungsschrauben 11 das Leistungsmodul 1 über die Führungen 18 der Brückenstruktur 17 an den Kühlkörper 9 andrücken.

Die vorliegende Erfindung weist viele Vorteile auf. Insbesondere ist der Aufbau einfach und kompakt, müssen in die Leiterplatte 13 weniger Ausnehmungen als im Stand der Technik eingebracht werden und können darüber hinaus sogar im Bereich um die Durchtrittsöffnungen 16 herum Leiterbahnen verlaufen. Die Entwicklungs- und Produktionskosten können verringert werden. Auch die Gesamtstabilität der elektronischen Leistungsbaugruppe kann oftmals verbessert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronische Leistungsbaugruppe,
- wobei die Leistungsbaugruppe ein Leistungsmodul (1) mit einer Moduloberseite (3) und einer Modulunterseite (4) aufweist,
- wobei die Leistungsbaugruppe einen Kühlkörper (9) aufweist, an den das Leistungsmodul (1) mit der Modulunterseite (4) über in den Kühlkörper (9) eingedrehte Befestigungsschrauben (11) angedrückt ist,
- wobei die Leistungsbaugruppe eine Leiterplatte (13) mit einer Leiterplattenoberseite (14) und einer Leiterplattenunterseite (15) aufweist,
- wobei die Leiterplatte (13) Durchtrittsöffnungen (16) für den Durchtritt der Befestigungsschrauben (11) aufweist,
- wobei die Leiterplatte (13) an der Moduloberseite (3) angeordnet ist, so dass die Leiterplattenunterseite (15) der Moduloberseite (3) zugewandt ist, und mit dem Leistungsmodul (1) mechanisch und elektrisch verbunden ist,
**dadurch gekennzeichnet,**
- **dass** die Leistungsbaugruppe eine aus einem elektrisch isolierenden Basismaterial, insbesondere einem Kunststoff, bestehende Brückenstruktur (17) aufweist,
- **dass** die Brückenstruktur (17) hülsenartige Führungen (18) aufweist, die über Verbindungsbereiche (19) der Brückenstruktur (17) miteinander verbunden sind,
- wobei die Verbindungsbereiche (19) oberhalb der Leiterplattenoberseite (14) mit einem Abstand (a) zur Leiterplattenoberseite (14) angeordnete Abschnitte (20) aufweisen, die an ihrer von der Leiterplatte (13) abgewandten Seite parallel zur Leiterplatte (13) verlaufende Montageflächen (21) bilden, so dass die Abschnitte (20) eine Montageebene für weitere Elemente (22) der Leistungsbaugruppe bereitstellen, und
- **dass** die Führungen (18) sich durch die Durchtrittsöffnungen (16) der Leiterplatte (13) hindurch zum Leistungsmodul (1) erstrecken, so dass die in den Kühlkörper (9) eingedrehten Befestigungsschrauben (11) das Leistungsmodul (1) über die Führungen (18) der Brückenstruktur (17) an den Kühlkörper (9) andrücken.

2. Leistungsbaugruppe nach Anspruch 1,
**dadurch gekennzeichnet,**
**dass** die Führungen (18) derart dimensioniert sind, dass Schraubenköpfe (23) der Befestigungsschrauben (11) oberhalb der Leiterplattenoberseite (14) angeordnet sind.

3. Leistungsbaugruppe nach Anspruch 2,
**dadurch gekennzeichnet,**
**dass** die Führungen (18) derart dimensioniert sind, dass die Schraubenköpfe (23) der Befestigungsschrauben (11) unterhalb der von den Abschnitten (20) bereitgestellten Montageebene angeordnet sind.

4. Leistungsbaugruppe nach Anspruch 1, 2 oder 3,
**dadurch gekennzeichnet,**
**dass** die Führungen (18) an ihren den Befestigungsschrauben (11) zugewandten Innenseiten Verstärkungshülsen (25) aus einem Zusatzmaterial aufweisen, das eine höhere Materialfestigkeit aufweist als das Basismaterial.

5. Leistungsbaugruppe nach einem der obigen Ansprüche,
**dadurch gekennzeichnet,**
**dass** die Brückenstruktur (17) an ihrer der Leiterplattenoberseite (14) zugewandten Seite elastische Andruckelemente (24) aufweist, mittels derer die Leiterplatte (13) an das Leistungsmodul (1) angedrückt wird.
